# EUROPEAN PATENT APPLICATION

(11) **EP 4 682 634 A1**
(43) Date of publication of application: **21.01.2026**
(21) Application number: 24770468.7
(22) Date of filing: 22.02.2024
(51) Int. Cl.: G03F 7/30, B41C 1/00, B41N 3/06, G03F 7/00

(54) **WASHING DEVICE AND METHOD FOR MANUFACTURING FLEXOGRAPHIC PRINTING PLATE ORIGINAL PLATE**

(30) Priority: 15.03.2023 JP 2023040762; 26.07.2023 JP 2023121385
(71) Applicant: FUJIFILM Corporation, Tokyo 106-8620 (JP)
(72) Inventor: SONE, Nobuyuki, Haibara-gun, Shizuoka 421-0396 (JP); TAJIMA, Seiji, Haibara-gun, Shizuoka 421-0396 (JP); OSHIMA, Atsushi, Haibara-gun, Shizuoka 421-0396 (JP)
(74) Representative: HGF
(86) International application number: PCT/JP2024/006467
(87) International publication number: WO 2024/190355

(57) **Abstract**

Provided are a washout processor and a method for manufacturing a flexographic printing plate precursor, which have good productivity and work efficiency. A washout processor that develops a flexographic printing plate precursor after imagewise exposure using a developer includes a station for attaching the flexographic printing plate precursor, and a measurement unit that measures at least one of a size or a thickness of the flexographic printing plate precursor and a position of the flexographic printing plate precursor on the station.

## Description

### BACKGROUND OF THE INVENTION

### 1. Field of the Invention

The present invention relates to a washout processor that develops a flexographic printing plate precursor after imagewise exposure using a developer and a method for manufacturing a flexographic printing plate precursor, and particularly to a washout processor that measures at least one of a size or a thickness of a flexographic printing plate precursor and a position of the flexographic printing plate precursor on a station, and a method for manufacturing a flexographic printing plate precursor.

### 2. Description of the Related Art

Various methods have been known as a method for developing a printing plate using a photosensitive resin plate in the related art. For example, in a developing method of carrying out development using an aqueous developer containing water as a main component, development is carried out by applying the aqueous developer to a photosensitive resin plate after imagewise exposure while washing out an uncured resin or the like, which is a non-exposed portion, with a brush or the like.

As a device that develops a printing plate using a photosensitive resin plate, various devices are available. For example, there are a device that develops a printing plate by fixing the printing plate to a flat plate called a setter with a pressure sensitive adhesive or the like, a device that develops a printing plate by fixing the printing plate to a rotating drum, and a device that develops a printing plate by fixing the printing plate to a transport bar.

For example, WO2019/206906A discloses a device for processing a relief plate precursor such as a printing plate precursor to be processed, the device comprising: a transport bar that includes at least one penetration element, preferably a plurality of penetration elements; and a plate-bonding station configured to bond the relief plate precursor to the transport bar by causing the at least one penetration element to penetrate into a non-perforated region near an edge portion of the relief plate precursor.

In addition, WO2021/069540A discloses a punching station in which an edge portion is directly bonded to a transport bar. WO2021/069540A discloses a punching station for disposing one or a plurality of penetration elements in an edge portion of a relief plate precursor or through the edge portion or for disposing one or a plurality of perforations in the edge portion, the punching station comprising: a punching unit including one or a plurality of penetration elements or perforating elements, the punching unit being configured to dispose one or a plurality of penetration elements or perforating elements through the edge portion of the relief plate precursor or in the edge portion; an abutment unit aligned with the punching unit and configured to form an abutment on an edge of the relief plate precursor; a detection unit configured to detect whether or not the edge portion of the relief plate precursor is correctly positioned with respect to the abutment unit at two or more locations along the abutment unit; and a signaling unit configured to perform signal communication in a function of detection of the detection unit.

### SUMMARY OF THE INVENTION

Currently, photosensitive resin plates are available in a variety of sizes and thicknesses. In a case of carrying out development, in order to carry out proper development, it is necessary to input a plate size and a thickness of the photosensitive resin plate to a developing machine and to operate the developing machine. The input of the plate size and the thickness cannot be fully automated because it is a manual process. Therefore, human errors due to incorrect input of the plate size and the thickness often occur. This leads to a decrease in plate-making yield and an increase in unnecessary work, resulting in deterioration in productivity and work efficiency. In addition, in a case where the plate size and the thickness of the photosensitive resin plate are not correct, proper development may not be carried out, which may result in development defects, and thus re-plate making may be required.

In WO2019/206906A and WO2021/069540A, the plate size and the thickness are not measured, so that it is necessary to input the plate size and the thickness, and thus the productivity and the work efficiency are deteriorated. In addition, as described above, proper development may not be carried out, development failure may occur, and thus re-plate making may be required.

In addition, in a case where the photosensitive resin plate is installed in a tilted state in a case where the photosensitive resin plate is set in the developing machine, transport failure or development failure of the photosensitive resin plate may occur, and thus re-plate making may be required.

An object of the present invention is to provide a washout processor and a method for manufacturing a flexographic printing plate precursor, which have good productivity and work efficiency.

In order to achieve the above-described object, an invention [1] is a washout processor that develops a flexographic printing plate precursor after imagewise exposure using a developer, the washout processor comprising: a station for attaching the flexographic printing plate precursor; and a measurement unit that measures at least one of a size or a thickness of the flexographic printing plate precursor and a position of the flexographic printing plate precursor on the station.

An invention [2] is the washout processor according to the invention [1], in which the measurement unit includes a camera that images the flexographic printing plate precursor.

An invention [3] is the washout processor according to the invention [1] or [2], which further comprises: a plate position adjustment unit that changes the position of the flexographic printing plate precursor on the station based on the at least one of the size or the thickness of the flexographic printing plate precursor measured by the measurement unit and the position of the flexographic printing plate precursor on the station.

An invention [4] is the washout processor according to any one of the inventions [1] to [3], which further comprises: a punching portion that punches a leading end part of the flexographic printing plate precursor.

An invention [5] is the washout processor according to any one of the inventions [1] to [4], which further comprises: a plate attachment portion that attaches a leading end leader to the flexographic printing plate precursor on the station.

An invention [6] is the washout processor according to the invention [5], in which the leading end leader extends and retracts in a direction perpendicular to a surface of the station.

An invention [7] is the washout processor according to any one of the inventions [1] to [6], in which the flexographic printing plate precursor is developed using the developer in a developing tank, and the washout processor includes a transport section that positions a transport position of the flexographic printing plate precursor in the developing tank at a predetermined position in a transport direction of the flexographic printing plate precursor during the development.

An invention [8] is the washout processor according to any one of the inventions [1] to [7], which further comprises: a developing section that performs the development by removing a non-exposed portion of the flexographic printing plate precursor using the developer, in which the developing section has a brush used for the development.

An invention [9] is the washout processor according to the invention [8], which further comprises: a height position adjustment unit that adjusts a position of the brush of the developing section with respect to the developing tank, in which the height position adjustment unit adjusts a position of the brush with respect to the flexographic printing plate precursor based on the thickness of the flexographic printing plate precursor obtained by the measurement unit.

An invention [10] is the washout processor according to any one of the inventions [1] to [9], which further comprises: an inspection unit that measures a surface shape of the flexographic printing plate precursor after development and inspects a development state.

An invention [11] is the washout processor according to any one of the inventions [1] to [9], which further comprises: an adjustment unit that adjusts a position of the measurement unit.

An invention [12] is the washout processor according to the invention [8] or [9], which further comprises: a rear end pressing portion that presses a rear end of the flexographic printing plate precursor.

An invention [13] is a method for manufacturing a flexographic printing plate precursor using the washout processor according to any one of the inventions [1] to [12].

According to the present invention, it is possible to provide a washout processor and a method for manufacturing a flexographic printing plate precursor, which have good productivity and work efficiency.

### BRIEF DESCRIPTION OF THE DRAWINGS

Fig. 1 is a schematic side sectional view showing an example of a washout processor of an embodiment of the present invention.
Fig. 2 is a schematic plan view showing an example of the washout processor of the embodiment of the present invention.
Fig. 3 is a schematic view showing an example of position adjustment of a flexographic printing plate precursor performed by the washout processor of the embodiment of the present invention.
Fig. 4 is a schematic plan view showing a transport form of the flexographic printing plate precursor of the embodiment of the present invention.
Fig. 5 is a schematic view showing an example of attachment of the flexographic printing plate precursor performed by a punching portion of the washout processor of the embodiment of the present invention.
Fig. 6 is a schematic side sectional view for describing development using an example of the washout processor of the embodiment of the present invention.
Fig. 7 is a flowchart showing a method of manufacturing a flexographic printing plate precursor of the embodiment of the present invention.
Fig. 8 is a schematic side sectional view showing another example of the washout processor of the embodiment of the present invention.
Fig. 9 is a schematic plan view showing another example of the washout processor of the embodiment of the present invention.
Fig. 10 is a schematic view showing a rear end pressing portion for the flexographic printing plate precursor in another example of the washout processor of the embodiment of the present invention.
Fig. 11 is a schematic view showing another example of the rear end pressing portion for the flexographic printing plate precursor in another example of the washout processor of the embodiment of the present invention.

### DESCRIPTION OF THE PREFERRED EMBODIMENTS

Hereinafter, a washout processor and a method for manufacturing a flexographic printing plate precursor according to an embodiment of the present invention will be described in detail based on preferred embodiments shown in the accompanying drawings.

The figures described below are examples for explaining the present invention, and the present invention is not limited to the figures shown below.

In the following, the term "to" indicating a numerical range includes numerical values described on both sides of the "to". For example, in a case where ε is a numerical value ε_{α} to a numerical value ε_{β}, a range of ε is a range including the numerical value ε_{α} and the numerical value ε_{β} and is represented by ε_{α} ≤ ε ≤ ε_{β} in mathematical symbols.

In addition, "orthogonal", "parallel", and a specific angle include a range of errors generally acceptable in the corresponding technical field unless particularly stated otherwise. Further, a numerical value or the like includes a range of errors generally acceptable in the corresponding technical field unless particularly stated otherwise.

### [Example of Washout Processor]

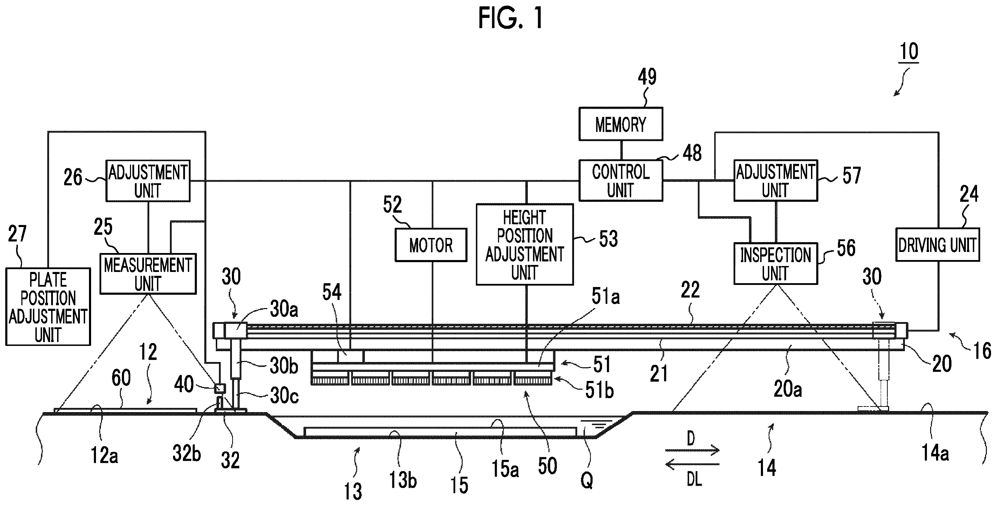

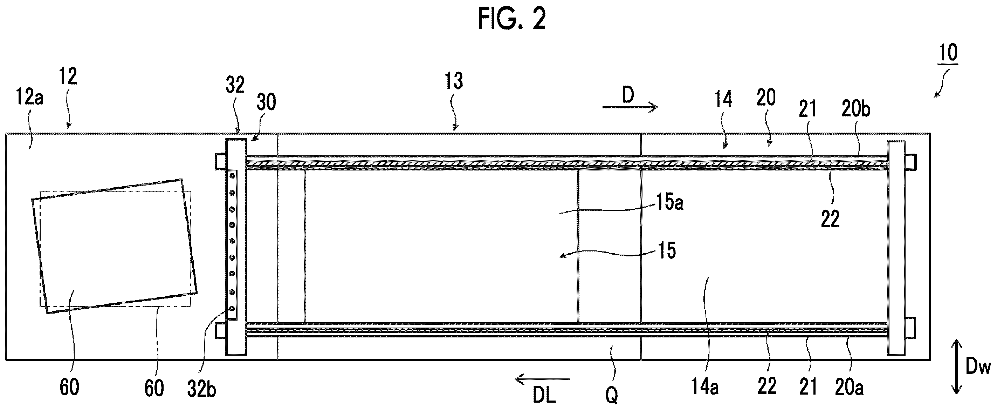

Fig. 1 is a schematic side sectional view showing an example of a washout processor of an embodiment of the present invention. Fig. 2 is a schematic plan view showing an example of the washout processor of the embodiment of the present invention. In Fig. 2, a configuration of a control unit 48 and the like shown in Fig. 1 is not shown. Further, a developing section 50 including a brush 51 is also not shown.

A washout processor 10 shown in Fig. 1 develops a flexographic printing plate precursor 60 after imagewise exposure using a developer Q. Each unit of the washout processor 10 shown below is controlled by the control unit 48.

The washout processor 10 is provided with a station 12, a developing tank 13, and an unloading station 14 in a continuous manner. For example, a surface 12a of the station 12 and a surface 14a of the unloading station 14 are on the same plane. A bottom surface 13b of the developing tank 13 is a flat surface and is parallel to the surface 12a of the station 12. The bottom surface 13b of the developing tank 13 is lowered relative to the surface 12a of the station 12 and the surface 14a of the unloading station 14.

Further, the washout processor 10 includes a transport section 16 that transports the flexographic printing plate precursor 60.

The flexographic printing plate precursor 60 after imagewise exposure is placed on the surface 12a of the station 12. A measurement unit 25 measures, on the station 12, at least one of a size or a thickness of the flexographic printing plate precursor 60 and a position of the flexographic printing plate precursor 60 on the station 12.

In addition, the station 12 is a place where the flexographic printing plate precursor 60 is attached to, for example, a leading end leader 30.

Although not shown, the station 12 can use, for example, a belt conveyor or a roller conveyor. The belt conveyor or the roller conveyor may have a general configuration. In a case of the belt conveyor, the surface 12a of the station 12 is a surface of the conveyor belt. In a case of the roller conveyor, a surface in contact with a plurality of rollers is the surface 12a of the station 12.

A front surface 60a of the flexographic printing plate precursor 60 is imagewise exposed using an exposure device (not shown). Here, in the flexographic printing plate precursor 60, an exposed portion (not shown) is cured and exists as a cured portion, and a non-exposed portion (not shown) is not cured and exists as an uncured portion. After undergoing the development step, the exposed portion becomes an image area, and the non-exposed portion becomes a non-image area.

The developing tank 13 is a place where the flexographic printing plate precursor 60 is developed. For example, a support table 15 that supports the flexographic printing plate precursor 60 is disposed on the bottom surface 13b of the developing tank 13. The flexographic printing plate precursor 60 is placed and supported on the surface 15a of the support table 15. In addition, a developer Q is stored in the developing tank 13.

The unloading station 14 is a place where the flexographic printing plate precursor 60 after development is unloaded from the developing tank 13 and placed. On the unloading station 14, a surface shape of the flexographic printing plate precursor 60 after development is measured, and a development state is inspected. The unloading station 14 is also a place where the flexographic printing plate precursor 60 after development is dried.

Although not shown, a belt conveyor or a roller conveyor can be used as the unloading station 14. The belt conveyor and the roller conveyor may have a general configuration. In a case of the belt conveyor, the surface 14a of the unloading station 14 is a surface of the conveyor belt. In a case of the roller conveyor, a surface in contact with a plurality of rollers is the surface 14a of the unloading station 14.

The transport section 16 transports the flexographic printing plate precursor 60 in a transport direction D and in a reverse direction DL opposite to the transport direction D. The transport section 16 can move the flexographic printing plate precursor 60 to any position of the station 12, the developing tank 13, and the unloading station 14.

The transport direction D is a direction from the station 12 toward the developing tank 13. The reverse direction DL opposite to the transport direction D is a direction from the unloading station 14 to the developing tank 13.

In the washout processor 10, the flexographic printing plate precursor 60 is transported in the transport direction D with the front surface 60a facing a frame 20 described below. The transport of the flexographic printing plate precursor 60 in this manner is referred to as horizontal transport.

The transport section 16 includes, for example, a frame 20, guide rails 21, ball screws 22, and a driving unit 24.

As shown in Fig. 2, the frame 20 has two linear members 20a and 20b. The two linear members 20a and 20b are disposed to be parallel to each other and are disposed above the station 12, the developing tank 13, and the unloading station 14 along a direction in which the station 12, the developing tank 13, and the unloading station 14 are arranged.

The guide rail 21 is provided on each of the two linear members 20a and 20b of the frame 20 along a direction in which the linear members 20a and 20b extend.

The ball screw 22 is provided on the guide rail 21 of the linear member 20a in a direction in which the linear member 20a extends. The ball screw 22 is provided on the guide rail 21 of the linear member 20b in a direction in which the linear member 20b extends.

A housing 30a of the leading end leader 30, which will be described below, is screwed to the ball screw 22. In a case where the ball screw 22 is rotated by the driving unit 24, the leading end leader 30 moves in the transport direction D or in the reverse direction DL according to a rotation direction. As a result, the flexographic printing plate precursor 60 is transported in the transport direction D and in the reverse direction DL. In addition, for example, in a case where the driving unit 24 is a servo motor provided with an encoder, a position of a member screwed to the ball screw 22 is specified by the encoder, that is, positions of the leading end leader 30 and the flexographic printing plate precursor 60 in the transport direction are specified. Even in a case where a linear encoder is provided on a member screwed to the ball screw 22 instead of the driving unit 24, the positions of the leading end leader 30 and the flexographic printing plate precursor 60 in the transport direction can be specified.

Information on the positions of the leading end leader 30 and the flexographic printing plate precursor 60 in the transport direction is output from the driving unit 24 to the control unit 48, and the control unit 48 specifies the positions of the leading end leader 30 and the flexographic printing plate precursor 60 in the transport direction.

It is preferable that the ball screws 22 are provided in the two linear members 20a and 20b, but the present invention is not limited to this. The ball screw 22 may be provided on either one of the two linear members 20a and 20b.

In addition, in the washout processor 10, a configuration may be adopted in which one ball screw 22 is provided at an intermediate position between the two linear members 20a and 20b in the direction Dw orthogonal to the transport direction D on the station 12. In a case where one ball screw 22 is provided between the two linear members 20a and 20b in the direction Dw orthogonal to the transport direction D on the station 12, the disposition position thereof is not particularly limited.

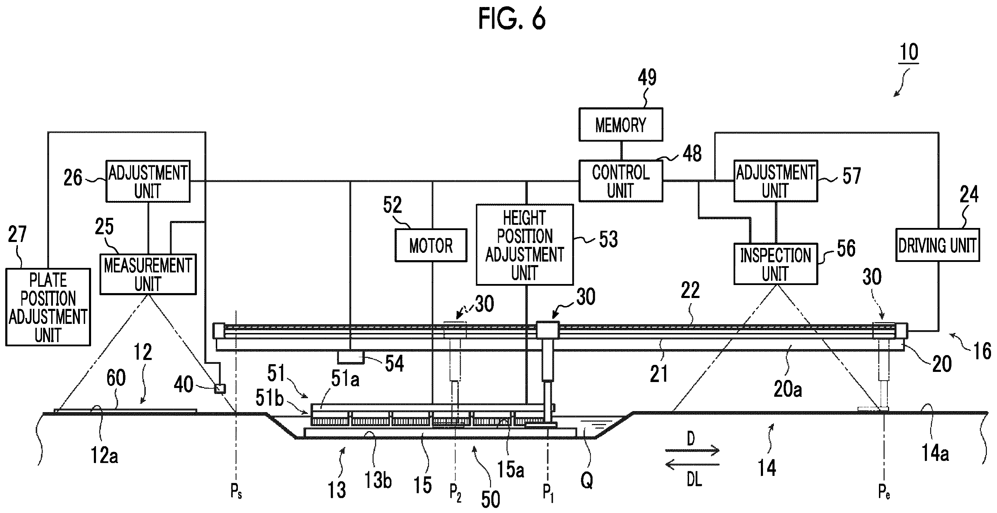

During development, the transport section 16 positions a transport position of the flexographic printing plate precursor 60 in the developing tank 13 at a predetermined position in the transport direction D of the flexographic printing plate precursor 60. As described below, the transport section 16 positions the flexographic printing plate precursor 60 at transport positions P₁ and P₂ (see Fig. 6) during development.

As shown in Fig. 1, the washout processor 10 has the measurement unit 25. The measurement unit 25 is disposed above the station 12. In addition, the measurement unit 25 is provided with an adjustment unit 26, for example.

The measurement unit 25 measures at least one of the size or the thickness of the flexographic printing plate precursor 60 and the position of the flexographic printing plate precursor 60 on the station 12. The measurement unit 25 specifies a position of the flexographic printing plate precursor 60 on the station 12. As a result, the position of the flexographic printing plate precursor 60 on the station 12, including its inclination, is specified. In addition, the size of the flexographic printing plate precursor 60 is also specified.

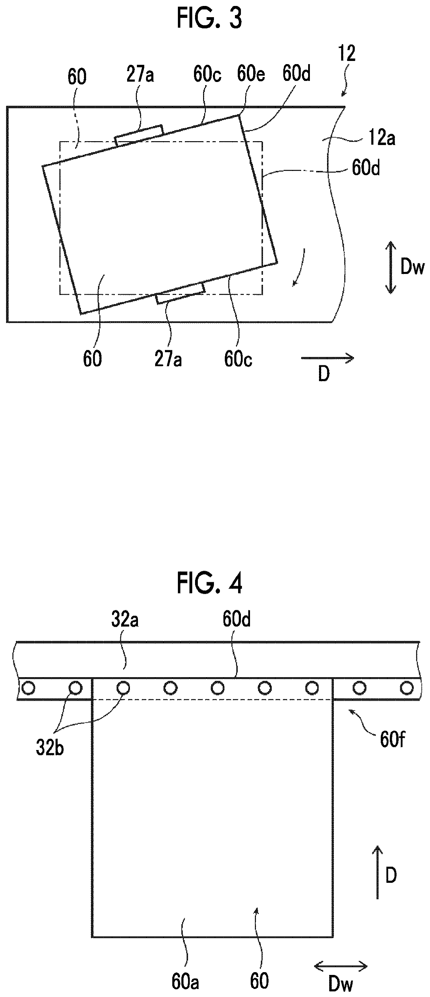

The position of the flexographic printing plate precursor 60 on the station 12 includes an inclination based on a line (not shown) parallel to the direction Dw (see Fig. 2) orthogonal to the transport direction D on the station 12 as a reference line (not shown) and a position in the direction Dw of a corner 60e (see Fig. 3) of the flexographic printing plate precursor 60 on the transport direction D side. The inclination and the position in the direction Dw of the corner 60e (see Fig. 3) are determined, for example, by extracting a contour of the flexographic printing plate precursor 60 and using a known image processing technique or known image pattern matching from contour information. For the pattern matching of the image, a machine-learned model trained on the flexographic printing plate precursor 60 of various sizes and thicknesses can also be used.

The information on the size and the thickness of the flexographic printing plate precursor 60 and the position of the flexographic printing plate precursor 60 on the station 12 obtained by the measurement unit 25 is stored in, for example, a memory 49. The information on the position of the flexographic printing plate precursor 60 on the station 12 is also simply referred to as information on the position of the flexographic printing plate precursor 60.

The information on the size and the thickness of the flexographic printing plate precursor 60 and the position of the flexographic printing plate precursor 60 stored in the memory 49 is read out from the memory 49 by the control unit 48 in a case where the flexographic printing plate precursor 60 is transported, and is used for adjusting the position of the flexographic printing plate precursor 60 and the positioning of the transport positions P₁ and P₂ (see Fig. 6) of the flexographic printing plate precursor 60 by the transport section 16.

In addition, the information on the size and the thickness of the flexographic printing plate precursor 60 and the position of the flexographic printing plate precursor 60 stored in the memory 49 is read out from the memory 49 by the control unit 48 in a case where the flexographic printing plate precursor 60 is developed, and is used for adjusting the position of the brush 51 during the development.

From the information on the size of the flexographic printing plate precursor 60, information on a length of the flexographic printing plate precursor 60 in the transport direction D and information on a length of the flexographic printing plate precursor 60 in the direction Dw are obtained.

The measurement unit 25 is not particularly limited as long as it can measure at least one of the size or the thickness of the flexographic printing plate precursor 60 and the position of the flexographic printing plate precursor 60 on the station 12 as described above. For example, as the measurement unit 25, a measurement device comprising a camera that images the flexographic printing plate precursor 60, a three-dimensional measurement device using two cameras, or a three-dimensional scanner using laser light or an ultrasonic wave can be used.

The camera that images the flexographic printing plate precursor 60 is, for example, an imaging camera that images the flexographic printing plate precursor 60 from above the station 12. The camera is not particularly limited as long as it can image the flexographic printing plate precursor 60, and, for example, a camera having a charge coupled device (CCD) image sensor or a complementary metal oxide semiconductor (CMOS) image sensor can be used.

It is preferable to use the three-dimensional measurement device or the three-dimensional scanner as the measurement unit 25, since this makes it possible to acquire the information on the size and thickness of the flexographic printing plate precursor 60 and the position of the flexographic printing plate precursor 60. As the three-dimensional measurement device, for example, a three-dimensional measurement device manufactured by KEYENCE CORPORATION or Mech-Mind Co., Ltd. can be used. As the three-dimensional scanner, a three-dimensional scanner manufactured by KEYENCE CORPORATION can be used.

In addition, a handheld three-dimensional scanner can also be used as the three-dimensional scanner. Further, the information on the size and the thickness of the flexographic printing plate precursor 600 and the position of the flexographic printing plate precursor 60 can also be acquired by attaching the handheld three-dimensional scanner to a multi-axis robot and operating the multi-axis robot with the handheld three-dimensional scanner.

The adjustment unit 26 adjusts a position of the measurement unit 25. In a case where the measurement unit 25 includes, for example, a camera, a three-dimensional measurement device, or a three-dimensional scanner, the adjustment unit 26 changes a distance between the camera, the three-dimensional measurement device, or the three-dimensional scanner and the surface 12a of the station 12. That is, the adjustment unit 26 adjusts a height position of the measurement unit 25 with respect to the surface 12a of the station 12. The adjustment unit 26 may change a position of the measurement unit 25 in the transport direction D.

In addition, the adjustment unit 26 may perform adjustment such as changing an orientation of the camera, the three-dimensional measurement device, or the three-dimensional scanner.

The configuration of the adjustment unit 26 is not particularly limited as long as at least the distance between the measurement unit 25 and the surface 12a of the station 12 can be changed.

The adjustment unit 26 can dispose the measurement unit 25 at a position corresponding to a measurement range of the measurement unit 25.

The washout processor 10 has a plate position adjustment unit 27. The plate position adjustment unit 27 changes the position of the flexographic printing plate precursor 60 on the station 12 based on the information on at least one of the size or the thickness of the flexographic printing plate precursor 60 measured by the measurement unit 25 and the position of the flexographic printing plate precursor 60.

The plate position adjustment unit 27 is, for example, a multi-axis robot.

In a case where the plate position adjustment unit 27 is a multi-axis robot, for example, as shown in Fig. 3, in a case where the flexographic printing plate precursor 60 is disposed at an angle, the plate position adjustment unit 27 clamps opposing side edges 60c of the flexographic printing plate precursor 60 with a pair of arms 27a, and then rotates the flexographic printing plate precursor 60 to correct the position of the flexographic printing plate precursor 60, for example, based on the size of the flexographic printing plate precursor 60 and the position of the flexographic printing plate precursor 60 on the station 12. In this case, for example, the flexographic printing plate precursor 60 is rotated using the pair of arms 27a such that a side 60d of the flexographic printing plate precursor 60 on the transport direction D side is parallel to the direction Dw orthogonal to the transport direction D within the surface 12a of the station 12.

The control unit 48 may cause the measurement unit 25 to measure the position of the flexographic printing plate precursor 60 after the position of the flexographic printing plate precursor 60 is adjusted by the plate position adjustment unit 27. As a result, the position of the flexographic printing plate precursor 60 on the station 12 after the position adjustment can be specified.

The control unit 48 may be configured to determine whether or not the position of the flexographic printing plate precursor 60 on the station 12 is proper based on the information on the size and the thickness of the flexographic printing plate precursor 60 and the position of the flexographic printing plate precursor 60 obtained by the measurement unit 25. For example, a proper position including the inclination of the flexographic printing plate precursor 60 on the station 12 is determined in advance, and a threshold value is set for the printing position. In a case where the threshold value is exceeded, the position of the flexographic printing plate precursor 60 on the station 12 is changed. The proper position and the threshold value for the proper position are stored in, for example, the memory 49. The threshold value is set for example, with respect to the position in the direction Dw of the corner 60e of the flexographic printing plate precursor 60 on the transport direction D side and the inclination of the side 60d of the leading end with respect to the direction Dw.

In addition, after correcting the position of the flexographic printing plate precursor 60, the control unit 48 may measure the size and the thickness of the flexographic printing plate precursor 60 and the position of the flexographic printing plate precursor 60 using the measurement unit 25, and determine whether or not the position of the flexographic printing plate precursor 60 on the station 12 is proper.

The plate position adjustment unit 27 is not limited to the multi-axis robot. For example, a rotary table provided on the station 12 may be used. The inclination of the flexographic printing plate precursor 60 may be adjusted by rotating the rotary table.

In addition, the inclination of the flexographic printing plate precursor 60 may be adjusted by disposing a plurality of belt conveyors of the station 12 and adjusting the direction of the transport of the belt conveyor.

As described above, after the position of the flexographic printing plate precursor 60 is adjusted by the multi-axis robot or the like, the flexographic printing plate precursor 60 is transported to a punching portion 40 of the leading end leader 30 by using the multi-axis robot. The transporting method is not limited to the use of the multi-axis robot, and the transport may be performed using a belt conveyor, a roller conveyor, or a vacuum suction pad.

The flexographic printing plate precursor 60 is transported by the transport section 16 using the leading end leader 30. The leading end leader 30 is transported from a start position Ps to a position Pe by the transport section 16.

The leading end leader 30 has the housing 30a that is screwed to the ball screw 22, an arm 30b that is provided on the housing 30a, and a support portion 30c that extends and retracts with respect to the arm 30b. The ball screw 22 is rotated by the driving unit 24, the housing 30a is moved in the transport direction D, and the leading end leader 30 is moved in the transport direction D.

The leading end leader 30 has the support portion 30c that extends and retracts with respect to the arm 30b, and the leading end leader 30 extends and retracts in a direction perpendicular to the surface 12a of the station 12.

The arm 30b and the support portion 30c extend in a direction from the frame 20 toward the surface 12a of the station 12. A plate fixing portion 32 is provided at an end of the support portion 30c opposite to the arm 30b.

The housings 30a, the arms 30b, and the support portions 30c are disposed facing each other on either side of the plate fixing portion 32 in the direction Dw.

The plate fixing portion 32 includes, for example, a long base 32a and a plurality of pins 32b provided at equal intervals along a longitudinal direction of the base 32a, as shown in Fig. 4. As shown in Fig. 4, the flexographic printing plate precursor 60 is fixed to the leading end leader 30 by using the pins 32b. The longitudinal direction of the base 32a is a direction parallel to the direction Dw orthogonal to the transport direction D (see Fig. 4).

The leading end leader 30 of the flexographic printing plate precursor 60 is configured to fix the flexographic printing plate precursor 60 using the pins 32b, but the shape, the number, and the disposition interval of the pins 32b are not particularly limited. The pins 32b are preferably disposed with a gap therebetween for ease of removal of the flexographic printing plate precursor 60. In a case of fixing the flexographic printing plate precursor 60, it is preferable that the pins 32b do not generate scum or the like in order not to contaminate an exposure surface of the flexographic printing plate precursor 60, that is, the front surface 60a, or not to contaminate the developer Q in the developing tank 13.

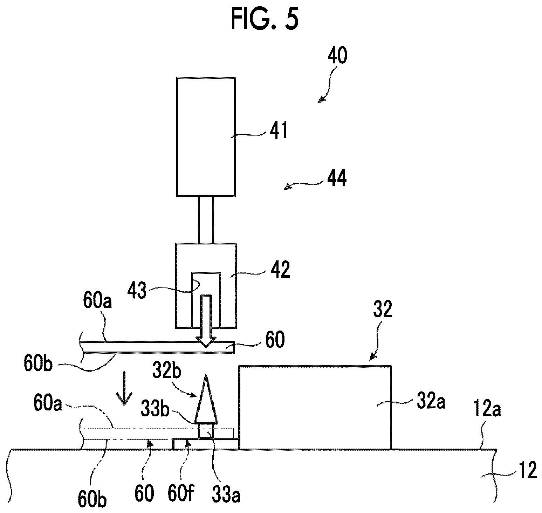

The pin 32b has, for example, a barb. The barb makes it difficult for the flexographic printing plate precursor 60 to come off the pin 32b, and the flexographic printing plate precursor 60 is reliably fixed. Therefore, it is preferable that the pin 32b has a barb. The barb is a portion where a base 33a (see Fig. 5) side of the pin 32b protrudes from the base 33a. Although the flexographic printing plate precursor 60 is fixed at the base 33a, a barb 33b, which protrudes from the base 33a, restricts the movement of the flexographic printing plate precursor 60 from moving toward the tip side of the pin 32b. In this manner, the barb makes it difficult for the flexographic printing plate precursor 60 to come off the pin 32b. As described above, in a case where the pin 32b penetrates the flexographic printing plate precursor 60, the barb 33b makes it difficult for the flexographic printing plate precursor 60 to come off the pin 32b, and the flexographic printing plate precursor 60 is reliably fixed.

In addition, it is preferable that at least a surface of the pin 32b that comes into contact with the flexographic printing plate precursor 60 has a resin layer, a plating layer, or a diamondlike carbon layer (DLC layer), or that the surface that comes into contact with the flexographic printing plate precursor 60 has a plurality of projections and recesses formed thereon.

A hard chrome plating layer is preferable as the plating layer. In addition, surface treatment with titanium nitride (TiN) or the like may be performed on the surface of the pin 32b that comes into contact with the flexographic printing plate precursor 60. As a result, the friction between the pin 32b and the flexographic printing plate precursor 60 is reduced, making it easier for the pin 32b to penetrate the flexographic printing plate precursor 60, and improving the durability of the pin 32b, allowing the pin 32b to be used repeatedly, which in turn improves the durability of the leading end leader 30.

The plurality of projections and recesses of the surface of the pin 32b that comes into contact with the flexographic printing plate precursor 60 are formed through, for example, embossing.

In order to fix the flexographic printing plate precursor 60 to the leading end leader 30 with the pins 32b, a punching portion 40 that punches a leading end part 60f of the flexographic printing plate precursor 60 is provided.

For example, the punching portion 40 is provided for each pin 32b. Therefore, in a case where there are a plurality of pins 32b, a plurality of punching portions 40 are provided according to the number of pins.

The punching portion 40 shown in Fig. 5 includes a driving unit 41 and a pushing unit 42. The pushing unit 42 has a recess portion 43. Since the recess portion 43 fits onto the pin 32b, it is preferable that an inner diameter of the recess portion 43 is larger than the maximum outer diameter of the pin 32b. As a result, the pin 32b can more reliably penetrate the flexographic printing plate precursor 60.

Here, the leading end part 60f of the flexographic printing plate precursor 60 is an end part of the flexographic printing plate precursor 60 on a traveling side in the transport direction D. The term "punching" means penetrating the flexographic printing plate precursor 60.

The configuration of the driving unit 41 is not particularly limited as long as it can move the pushing unit 42 from the first position toward the pin 32b and return it to the first position, and, for example, an air cylinder can be used. The first position is a position where the pushing unit 42 is installed, and is also called an initial position.

Since the pushing unit 42 punches the flexographic printing plate precursor 60 with the pin 32b and causes the pin 32b to penetrate the flexographic printing plate precursor 60, the pushing unit 42 preferably has a strength to prevent deformation, and is made of, for example, metal.

The pushing unit 42 is preferably martensitic stainless steel and austenitic stainless steel having quenching hardenability, which are resistant to abrasion in a case of perforating the flexographic printing plate precursor 60, among stainless steels that are resistant to rust. The martensitic stainless steel and the austenitic stainless steel correspond to stainless steels developed for blades, which are original brands of material manufacturers, such as stainless steel (SUS) 410, SUS 420J1, and SUS 420J2, as well as SUS 304 and SUS316. The pushing unit 42 may also be made of carbon tool steel, alloy tool steel, high speed tool steel, or super steel.

The flexographic printing plate precursor 60 is disposed such that a back surface 60b thereof faces the pin 32b of the leading end leader 30. The pushing unit 42 is disposed on the front surface 60a side of the flexographic printing plate precursor 60.

In a case where the recess portion 43 of the punching portion 40 and the position of the pin 32b of the leading end leader 30 are aligned and the driving unit 41 pushes the pushing unit 42 at the first position toward the pin 32b, the flexographic printing plate precursor 60 is pressed toward the pin 32b, the pin 32b punches the flexographic printing plate precursor 60, and the flexographic printing plate precursor 60 is fixed to the leading end leader 30. In this case, the pin 32b fits into the recess portion 43. Then, the driving unit 41 returns the pushing unit 42 to the initial position.

It is preferable that the length of the flexographic printing plate precursor 60 in the direction Dw (see Fig. 2) orthogonal to the transport direction D (see Fig. 2) of the flexographic printing plate precursor 60 is specified based on the information on the size of the flexographic printing plate precursor 60 obtained by the measurement unit 25, and the pin 32b to be used for punching is specified in accordance with the length and the information on the position of the flexographic printing plate precursor 60. As a result, it is not necessary to operate the punching portion 40 with respect to the pin 32b on which the flexographic printing plate precursor 60 is not disposed, thereby improving the work efficiency. The length of the flexographic printing plate precursor 60 in the direction Dw (see Fig. 2) is generally referred to as a width.

The punching portion 40 is used to attach the leading end leader 30 to the flexographic printing plate precursor 60 and also serves as a plate attachment portion 44. The leading end part 60f of the flexographic printing plate precursor 60 is disposed on the pin 32b. Thereafter, the flexographic printing plate precursor 60 is punched by the punching portion 40, and the flexographic printing plate precursor 60 is fixed to the leading end leader 30.

In a case where the plate position adjustment unit 27 is a multi-axis robot, the multi-axis robot can dispose the leading end part 60f of the flexographic printing plate precursor 60 on the pin 32b.

In addition, the punching portion 40 also serves as the plate attachment portion 44, but the present invention is not limited to this. For example, the punching portion 40 and the plate attachment portion 44 may be separated, and a through-hole (not shown) for attaching the flexographic printing plate precursor 60 to the leading end leader 30 may be formed by the punching portion 40, and then the leading end leader 30 may be attached to the flexographic printing plate precursor 60 by passing the pin 32b through the through-hole in the leading end part 60f of the flexographic printing plate precursor 60.

The configuration of the leading end leader 30 is not particularly limited as long as the support portion 30c can extend and retract with respect to the arm 30b. Examples of the configuration in which the support portion 30c extends and retracts with respect to the arm 30b include a configuration in which an elastic body such as a spring or rubber is used, a configuration in which air pressure is used, and a configuration in which hydraulic pressure is used.

The washout processor 10 includes a developing section 50 that performs development by removing a non-exposed portion (not shown) of the flexographic printing plate precursor 60 using the developer Q. The developing section 50 is provided above the developing tank 13. The developing section 50 has a brush 51 used for development.

For example, the brush 51 is disposed, in the direction Dw, between the arms 30b and the support portions 30c disposed facing each other on either side of the plate fixing portion 32 in the direction Dw.

The brush 51 has, for example, a size larger than the size of the flexographic printing plate precursor 60 in plan view. The brush 51 is, for example, a brush in which bristles 51b are tufted perpendicularly to a quadrangular substrate 51a in plan view, and is called a flat brush. The substrate 51a is attached to a height position adjustment unit 53. The shape of the substrate 51a is the shape of the brush 51. The shape of the substrate 51a is not limited to a quadrangle in plan view.

For example, a motor 52 that causes the brush 51 to reciprocate during development is connected to the brush 51.

The operation of the brush 51 is not particularly limited, and may be any of rotation, reciprocation, a combination of rotation and reciprocation, or eccentric circular motion.

In addition, the brush 51 may be designed to move constantly during development, or the brush 51 may be designed to move only in a case where the flexographic printing plate precursor 60 is transported to the developing tank 13. In this case, for example, a sensor (not shown) for detecting the flexographic printing plate precursor 60 can be provided above the developing tank 13, and a transport speed of the flexographic printing plate precursor 60 can be used to specify a time when the brush 51 is reached, and the brush 51 can be rotated to perform development.

Further, the height position adjustment unit 53 that adjusts a position of the brush 51 with respect to the developing tank 13 is provided. The height position adjustment unit 53 specifies a distance between the brush 51 and the bottom surface 13b of the developing tank 13. The height position adjustment unit 53 can change the position of the brush 51 with respect to the bottom surface 13b of the developing tank 13. In addition, the height position adjustment unit 53 can adjust the pressure of the brush 51 on the front surface 60a of the flexographic printing plate precursor 60. As a result, the pressure of the brush 51 can be increased, and the development speed can be improved. In a case where the pressure of the brush 51 is increased, it is preferable that a material for the bristles of the brush 51, a length of each bristle, a thickness of each bristle, or the like corresponds to the pressure. The bristles in a central portion of one brush 51 may be made longer, the thickness of bristles in one brush 51 may be changed, or the density of the bristles in one brush 51 may be changed.

In addition, since the brush 51 can be spaced from the front surface 60a of the flexographic printing plate precursor 60 by the height position adjustment unit 53, the brush 51 can be lifted from the front surface 60a of the flexographic printing plate precursor 60. This allows development scum to be removed from the brush 51 in a case where it adheres to the brush 51. By retracting the brush 51 from the flexographic printing plate precursor 60, the adhesion of development scum is suppressed, which is preferable.

The configuration of the height position adjustment unit 53 is not particularly limited as long as the position of the brush 51 with respect to the bottom surface 13b of the developing tank 13 can be changed.

The brush 51 may be, for example, a cup brush. With the cup brush, it is preferable to position the brush bristles such that the bristles contact the front surface 60a of the flexographic printing plate precursor 60 at a substantially perpendicular angle.

The cup brush is smaller than the size of the flexographic printing plate precursor 60. Since the brush is small, the brush is moved relative to the flexographic printing plate precursor 60 during development, making it possible to uniformize the pressure of the brush and improve the development uniformity.

Further, since a brush area required for development can be reduced as the cup brush performs development by moving in a plane direction while the flexographic printing plate precursor 60 is transported, the washout processor can be simplified. The number of the cup brushes is not particularly limited and is appropriately determined depending on a size of the developing tank 13, the size of the flexographic printing plate precursor 60, and the like.

A roller-shaped brush can also be used as the brush 51. The roller-shaped brush is a brush in which bristles are tufted radially with respect to a rotation axis. The bristles of the roller-shaped brush can be the same as those of the brush 51 described above.

The roller-shaped brush is disposed such that the rotation axis thereof is parallel to the direction Dw. The number of the roller-shaped brushes is not particularly limited and is appropriately determined depending on the size of the developing tank 13, the size of the flexographic printing plate precursor 60, and the like.

For example, after the flexographic printing plate precursor 60 is transported into the developing tank 13, the height position adjustment unit 53 moves the brush 51 toward the flexographic printing plate precursor 60 based on information on the thickness of the flexographic printing plate precursor 60. As a result, the brush 51 can be disposed at an appropriate height position according to the thickness of the flexographic printing plate precursor 60, enabling proper development. For example, development can be carried out with the bristles 51b of the brush 51 in contact with the front surface 60a of the flexographic printing plate precursor 60.

In addition, a distance sensor 54 for measuring a distance between the brush 51 and the front surface 60a of the flexographic printing plate precursor 60 in the developing tank 13 may be provided. As a result, it is possible to obtain information on the thickness of the flexographic printing plate precursor 60 in a case where the thickness of the flexographic printing plate precursor 60 is not measured by the measurement unit 25.

The distance sensor 54 is not particularly limited as long as it can measure the distance between the brush 51 and the front surface 60a of the flexographic printing plate precursor 60 in the developing tank 13. As the distance sensor 54, for example, a sensor using laser light, a millimeter wave, or an ultrasonic wave can be used.

The washout processor 10 includes, for example, an inspection unit 56 that measures the surface shape of the flexographic printing plate precursor 60 after development and that inspects the development state. The inspection unit 56 is disposed above the unloading station 14.

A reference value and an allowable range for the reference value are set in advance with respect to the surface shape after development, and are stored in the memory 49.

For example, the inspection unit 56 determines whether or not development has been properly carried out based on a measurement result of the surface shape after development and the allowable range for the reference value.

As the reference value, for example, the presence or absence of development scum, the presence or absence of brush marks, and the unexposed film thickness after development can be used.

The inspection unit 56 is not particularly limited as long as it can measure the surface shape of the flexographic printing plate precursor 60 after development, and, for example, a measurement device using one camera, a three-dimensional measurement device using two cameras, or a three-dimensional scanner using laser light or an ultrasonic wave can be used, as with the measurement unit 25. It is preferable to use the three-dimensional measurement device or the three-dimensional scanner as the inspection unit 56, since it is possible to acquire three-dimensional information on the surface shape of the flexographic printing plate precursor 60 after development.

In addition, the inspection unit 56 may be provided with an adjustment unit 57 that adjusts a position of the inspection unit 56, as with the measurement unit 25.

In a case where the inspection unit 56 has, for example, a camera, a three-dimensional measurement device, or a three-dimensional scanner, the adjustment unit 57 changes a distance between the camera, the three-dimensional measurement device, or the three-dimensional scanner and the surface 12a of the station 12. That is, the adjustment unit 57 adjusts a height position of the inspection unit 56 with respect to the surface 14a of the unloading station 14. The adjustment unit 57 may change a position of the inspection unit 56 in the transport direction D. In addition, the adjustment unit 57 may perform adjustment such as changing an orientation of the camera, the three-dimensional measurement device, or the three-dimensional scanner.

The configuration of the adjustment unit 57 is not particularly limited as long as at least the distance between the inspection unit 56 and the surface 14a of the unloading station 14 can be changed.

The adjustment unit 57 can dispose the inspection unit 56 at a position corresponding to a measurement range of the inspection unit 56.

With the above-described configuration, in the washout processor 10, at least one of the size or the thickness of the flexographic printing plate precursor 60 and the position of the flexographic printing plate precursor 60 on the station 12 are measured by the measurement unit 25. This suppresses the occurrence of human error caused by inputting the wrong size and thickness of the flexographic printing plate precursor 60. Therefore, it is possible to carry out proper development without a decrease in plate-making yield, an increase in unnecessary work, and occurrence of transport failure or development failure. In this way, productivity and work efficiency are good.

### <Method for Manufacturing Flexographic Printing Plate Precursor>

A method for manufacturing a flexographic printing plate precursor using the washout processor 10 will be described. In the method for manufacturing the flexographic printing plate precursor, a flexographic printing plate precursor after imagewise exposure is developed using a developer. The development is also referred to as washing out.

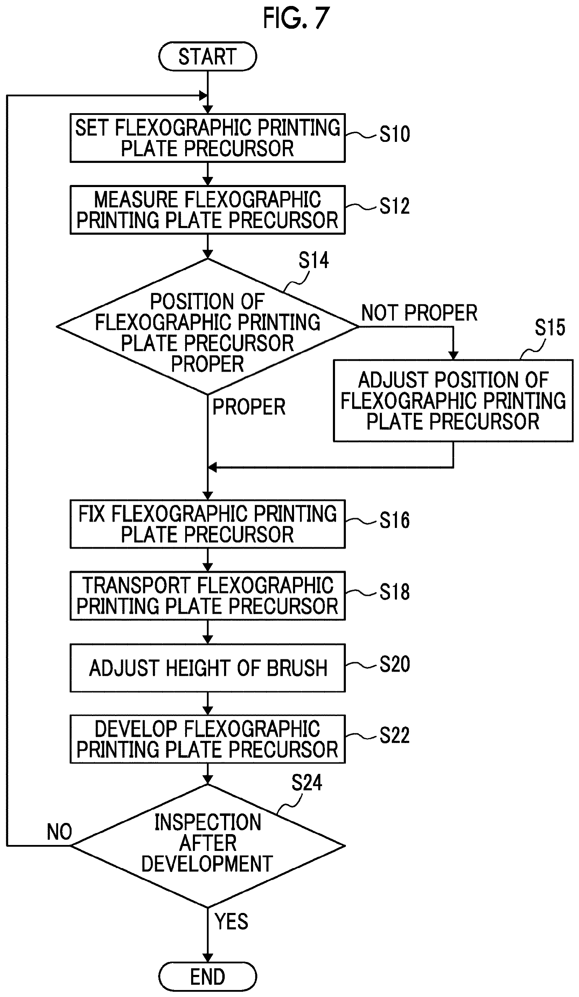

Fig. 6 is a schematic side sectional view for describing development using an example of the washout processor of the embodiment of the present invention, and Fig. 7 is a flowchart showing a method for manufacturing a flexographic printing plate precursor of the embodiment of the present invention. In Fig. 6, the same components as the washout processor 10 shown in Fig. 1 are denoted by the same reference numerals, and detailed description thereof will be omitted.

In the method for manufacturing the flexographic printing plate precursor, first, as shown in Fig. 6, a flexographic printing plate precursor 60 after imagewise exposure, which has a front surface 60a imagewise exposed, is placed on the surface 12a of the station 12 (step S10). Placing the flexographic printing plate precursor 60 on the surface 12a of the station 12 is also referred to as setting.

Next, in a state where the flexographic printing plate precursor 60 is placed on the station 12, the measurement unit 25 is used to measure, for example, the size and the thickness of the flexographic printing plate precursor 60 on the surface 12a of the station 12 and the position of the flexographic printing plate precursor 60 on the station 12 (step S12).

The information on the size and the thickness of the flexographic printing plate precursor 60 and the information on the position of the flexographic printing plate precursor 60 obtained by the measurement in step S12 are stored in, for example, the memory 49.

The control unit 48 specifies the position of the flexographic printing plate precursor 60 on the station 12 based on the information on the position of the flexographic printing plate precursor 60 and the information on the size of the flexographic printing plate precursor 60. As a result, the position of the flexographic printing plate precursor 60 in the direction Dw on the station 12 and the inclination of the flexographic printing plate precursor 60 are specified as described above. In addition, the size and the thickness of the flexographic printing plate precursor 60 are also specified.

Next, the control unit 48 determines whether or not the position of the flexographic printing plate precursor 60 on the station 12 is proper based on the information on the position of the flexographic printing plate precursor 60 on the station 12 (step S14).

As described above, for example, a proper position including the inclination of the flexographic printing plate precursor 60 is determined in advance, and a threshold value is set for the proper position.

In step S14, the control unit 48 determines whether or not the position of the flexographic printing plate precursor 60 on the station 12 is a proper position by comparing the position with the proper position.

In a case where it is determined in step S14 that the position of the flexographic printing plate precursor 60 is proper, the leading end part 60f of the flexographic printing plate precursor 60 is fixed to the leading end leader 30 (step S16).

In step S16, for example, the punching portion 40 shown in Fig. 5 is used to punch the flexographic printing plate precursor 60 with the pins 32b, and the flexographic printing plate precursor 60 is attached to the leading end leader 30. In this case, the pin 32b to be used for punching is specified among the plurality of pins 32b according to the position of the flexographic printing plate precursor 60 and the length of the flexographic printing plate precursor 60 in the direction Dw (see Fig. 2) orthogonal to the transport direction D (see Fig. 2) of the flexographic printing plate precursor 60.

On the other hand, in a case where it is determined in step S14 that the position of the flexographic printing plate precursor 60 is not proper, the position of the flexographic printing plate precursor 60 is adjusted using the plate position adjustment unit 27, for example, a multi-axis robot (step S15). Thereafter, the above-described step S16 is executed.

After step S15, the above-described step S14 may be executed again, and the adjustment of the position of the flexographic printing plate precursor 60 (step S15) may be repeatedly executed until it is determined in step S14 that the position of the flexographic printing plate precursor 60 is proper.

After step S16, the flexographic printing plate precursor 60 is transported into the developing tank 13 (step S18). The bottom surface 13b of the developing tank 13 is lowered relative to the surface 12a of the station 12. In this case, since the support portion 30c extends and retracts with respect to the arm 30b, the flexographic printing plate precursor 60 is transported following the bottom surface 13b of the developing tank 13.

Here, in the station 12, the length of the flexographic printing plate precursor 60 in the transport direction D (see Fig. 6) and the length of the flexographic printing plate precursor 60 in the direction Dw (see Fig. 2) are specified depending on the size of the flexographic printing plate precursor 60.

In step S18, in a case where a reference for aligning the flexographic printing plate precursor 60 is a rear end of the flexographic printing plate precursor 60, the position of the leading end leader 30 during development is changed according to the length of the flexographic printing plate precursor 60 in the transport direction D. Depending on the length of the flexographic printing plate precursor 60, for example, as shown in Fig. 6, the leading end leader 30 is set to at a transport position P₁ (see Fig. 6) and development is carried out. In addition, depending on the length of the flexographic printing plate precursor 60, for example, the leading end leader 30 is set to at a transport position P₂ (see Fig. 6) and development is carried out.

The transport positions P₁ and P₂ are determined based on the length of the flexographic printing plate precursor 60 in the transport direction D. Therefore, the control unit 48 sets the amount of movement of the leading end leader 30 by the driving unit 24 in advance based on the information on the length of the flexographic printing plate precursor 60 in the transport direction D. As a result, the amount of movement of the leading end leader 30 by the driving unit 24 is set based on the information on the length of the flexographic printing plate precursor 60 in the transport direction D obtained by the measurement unit 25. That is, the amount of movement of the leading end leader 30 from the start position Ps is set. The start position Ps is a position where the flexographic printing plate precursor 60 is fixed to the leading end leader 30.

After the flexographic printing plate precursor 60 is transported into the developing tank 13 according to the length of the flexographic printing plate precursor 60 in the transport direction D (step S18), the height position adjustment unit 53 moves the brush 51 as shown in Fig. 6 based on the information on the thickness of the flexographic printing plate precursor 60. The height of the brush 51 with respect to the flexographic printing plate precursor 60 is adjusted to set the brush 51 to a proper position (step S20).

After the height adjustment of the brush (step S20), development is carried out on the flexographic printing plate precursor 60 using the developer Q (see Fig. 6) to remove the non-exposed portion of the flexographic printing plate precursor 60 to obtain an image area which is an exposed portion (step S22). In this way, through step S22, the exposed portion becomes an image area, and the non-exposed portion becomes a non-image area.

In step S22 (developing step), the flexographic printing plate precursor 60 is transported into the developing tank 13 according to the length of the flexographic printing plate precursor 60 in the transport direction D, and then the brush 51 is moved by the motor 52 in this state to carry out development. The development is carried out at the transport positions P₁ and P₂ (see Fig. 6) of the leading end leader 30 corresponding to the length of the flexographic printing plate precursor 60.

After step S22 (developing step), the flexographic printing plate precursor 60 is transported in the transport direction D, and is moved onto the unloading station 14 while the leading end leader 30 is moved to the position Pe. In this case, the surface 14a of the unloading station 14 is raised with respect to the bottom surface 13b of the developing tank 13. In this case, since the support portion 30c extends and retracts with respect to the arm 30b, the flexographic printing plate precursor 60 is transported following the surface 14a of the unloading station 14.

Then, the inspection unit 56 measures the surface shape of the flexographic printing plate precursor 60 after development and inspects the development state (step S24).

A reference value and an allowable range for the reference value are set in advance with respect to the surface shape after development. In step S24 (inspection step), the inspection is performed using the allowable range for the reference value.

In step S24, in a case where the surface shape after development is within the allowable range for the reference value, it is determined that the development has been properly carried out. As a result, the method for manufacturing the flexographic printing plate precursor 60 ends.

On the other hand, in step S24, in a case where the surface shape after development is outside the allowable range for the reference value, it is determined that the development has not been properly carried out. In this case, for example, re-plate making is performed. Specifically, the flexographic printing plate precursor 60 after imagewise exposure, which has the front surface 60a imagewise exposed, is newly prepared, and the process returns to step S10 to carry out development again. As described above, in a case where it is determined in step S24 that the development has not been properly carried out, the flexographic printing plate precursor 60 that has been developed once may be additionally developed.

As described above, in the method for manufacturing the flexographic printing plate precursor, at least one of the size or the thickness of the flexographic printing plate precursor 60 and the position of the flexographic printing plate precursor 60 on the station 12 are measured. This suppresses the occurrence of human error caused by inputting the wrong size and thickness of the flexographic printing plate precursor 60. Therefore, it is possible to carry out proper development without a decrease in plate-making yield, an increase in unnecessary work, and occurrence of transport failure or development failure. In this way, productivity and work efficiency are good.

### [Another Example of Washout Processor]

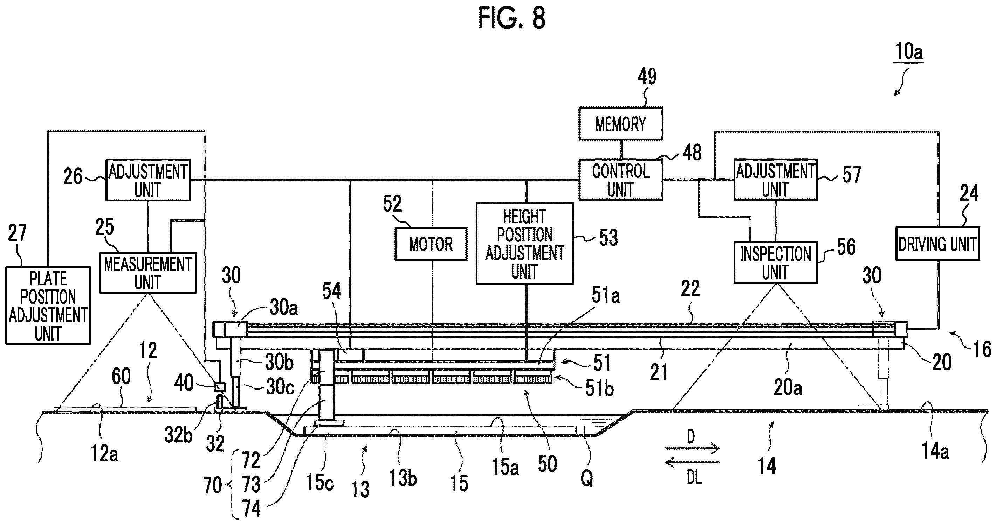

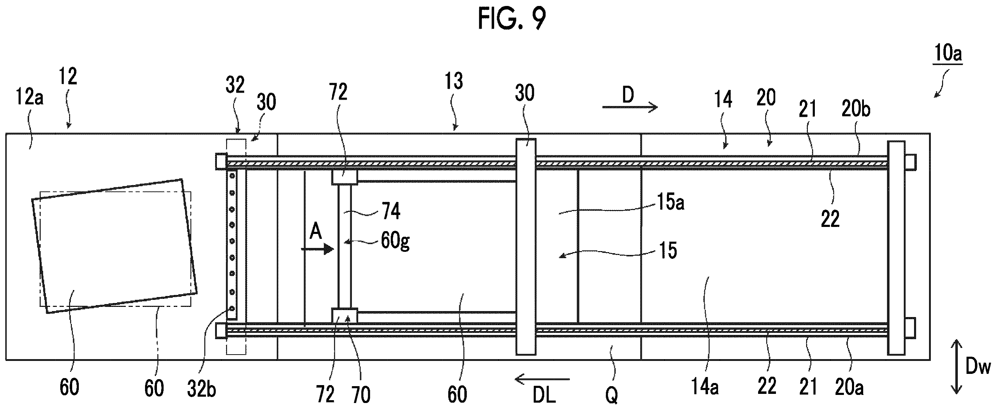

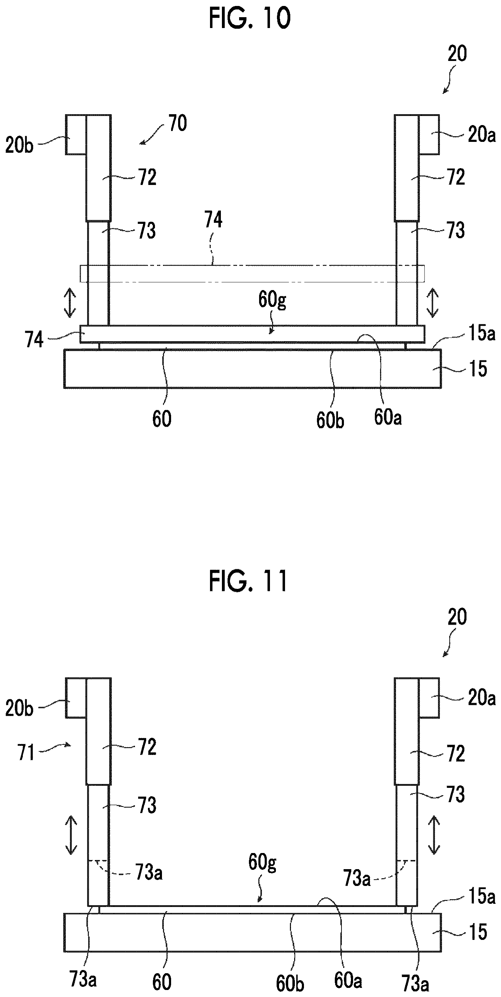

Fig. 8 is a schematic side sectional view showing another example of the washout processor of the embodiment of the present invention. Fig. 9 is a schematic plan view showing another example of the washout processor of the embodiment of the present invention. Fig. 10 is a schematic view showing a rear end pressing portion for the flexographic printing plate precursor in another example of the washout processor of the embodiment of the present invention, and Fig. 11 is a schematic view showing another example of the rear end pressing portion for the flexographic printing plate precursor in another example of the washout processor of the embodiment of the present invention.

In Fig. 8, the flexographic printing plate precursor 60 shown in Fig. 9 is not shown. In Fig. 9, the configuration of the control unit 48 and the like shown in Fig. 8 is not shown, and the developing section 50 including the brush 51 is also not shown.

Figs. 10 and 11 show rear end pressing portions 70 and 71 as viewed from a direction A shown in Fig. 9, respectively.

In addition, in Figs. 8 to 11, the same components as those of the washout processor 10 shown in Figs. 1 and 2 are denoted by the same reference numerals, and detailed description thereof will be omitted.

A washout processor 10a shown in Figs. 8 and 9 is different from the washout processor 10 shown in Figs. 1 and 2 in that a rear end pressing portion 70 that presses a rear end 60g of the flexographic printing plate precursor 60 is provided, and other configurations are the same as those of the washout processor 10 shown in Figs. 1 and 2.

The rear end pressing portion 70 is provided in the developing tank 13.

The rear end pressing portion 70 has a base 72, a support portion 73 that extends and retracts in a direction perpendicular to the surface 15a of the support table 15 with respect to the base 72, and a pressing plate 74 that is provided at an end of the support portion 73 on the surface 15a side of the support table 15.

The bases 72 are provided on sides of the member 20a and the member 20b where the member 20a and the member 20b face each other. Since the housing 30a of the leading end leader 30 passes over the base 72, the base 72 is disposed at a position where the base 72 does not interfere with the housing 30a of the leading end leader 30.

The support portion 73 extends and retracts in the direction perpendicular to the surface 15a of the support table 15 with respect to the base 72, for example, by using an air cylinder, a hydraulic cylinder, or a ball screw as a driving unit (not shown). In addition, the support portion 73 can be retracted with respect to the base 72 by a driving unit (not shown), so that an end of the support portion 73 can be positioned at a preset position. As a result, the pressing plate 74 can be stopped at a preset position in the direction perpendicular to the surface 15a of the support table 15.

In addition, the cross-sectional shape of the support portion 73 in a direction orthogonal to the direction of extension and retraction of the support portion 73 is not particularly limited, and may be, for example, a circular shape or a polygonal shape such as a triangular shape or a quadrangular shape.

The pressing plate 74 is, for example, a rectangular plate. In this case, the pressing plate 74 is disposed such that its longitudinal direction is aligned with the direction Dw. The pressing plate 74 is moved to the surface 15a side of the support table 15 by the support portion 73 to press the rear end 60g of the flexographic printing plate precursor 60 in a band shape in the direction Dw.

In a case where a reference for aligning the flexographic printing plate precursor 60 is the rear end 60g of the flexographic printing plate precursor 60, the position of the rear end pressing portion 70 remains fixed without change. Therefore, during development, the position of the leading end leader 30 in the transport direction D is changed according to the size of the flexographic printing plate precursor 60.

In the rear end pressing portion 70, for example, the pressing plate 74 is spaced from the surface 15a of the support table 15 such that the support portion 73 is retracted and the flexographic printing plate precursor 60 can pass through until the flexographic printing plate precursor 60 is transported into the developing tank 13 and reaches the rear end pressing portion 70.

As in the washout processor 10 shown in Figs. 1 and 2 described above, even with only the leading end leader 30, the flexographic printing plate precursor 60 can be prevented from curling up and being detached. However, by further providing the rear end pressing portion 70, the rear end 60g of the flexographic printing plate precursor 60 is pressed, so that the flexographic printing plate precursor 60 can be further prevented from curling up and being detached. Therefore, it is preferable to provide the rear end pressing portion 70.

In the washout processor 10a shown in Figs. 8 and 9, the flexographic printing plate precursor 60 is transported into the developing tank 13. In a case where a reference for aligning the flexographic printing plate precursor 60 is the rear end 60g of the flexographic printing plate precursor 60, the leading end leader 30 stops at a position in the transport direction D according to the length of the flexographic printing plate precursor 60 in the transport direction D. In this case, the pressing plate 74 is spaced from the surface 15a of the support table 15 and is disposed at a position where the rear end 60g of the flexographic printing plate precursor 60 can be positioned.

After the leading end leader 30 stops, the base 72 of the rear end pressing portion 70 extends toward the surface 15a of the support table 15, the flexographic printing plate precursor 60 is sandwiched between the pressing plate 74 and the surface 15a of the support table 15, thereby fixing the rear end 60g of the flexographic printing plate precursor 60. With the rear end 60g of the flexographic printing plate precursor 60 fixed, a development process is carried out. As described above, the development treatment is carried out without the flexographic printing plate precursor 60 being curled up and without the flexographic printing plate precursor 60 being detached.

After the development treatment is completed, the base 72 of the rear end pressing portion 70 is retracted, and the pressing plate 74 is spaced from the rear end 60g of the flexographic printing plate precursor 60. Thereafter, the leading end leader 30 moves in the transport direction D, and the flexographic printing plate precursor 60 is transported to the unloading station 14.

The configuration of the rear end pressing portion 70 is not limited to a configuration including the pressing plate 74 as shown in Fig. 10. For example, a configuration in which the pressing plate 74 is not provided as in the rear end pressing portion 71 shown in Fig. 11 may be adopted. In the rear end pressing portion 71 shown in Fig. 11, the same configurations as those of the rear end pressing portion 70 shown in Fig. 10 are denoted by the same reference numerals, and detailed description thereof will be omitted.

In the rear end pressing portion 71, the support portion 73 extends and retracts in the direction perpendicular to the surface 15a of the support table 15 with respect to the base 72, as with the rear end pressing portion 70 described above. In addition, an end 73a of the support portion 73 on the surface 15a side of the support table 15 is, for example, a flat surface. The rear end 60g of the flexographic printing plate precursor 60 is pressed by the end 73a of the support portion 73 which is configured as a flat surface. In the rear end pressing portion 71, the rear end 60g of the flexographic printing plate precursor 60 is pressed by two support portions 73, and the flexographic printing plate precursor 60 is locally pressed.

Similarly to the above-described pressing plate 74, in the rear end pressing portion 71, for example, the end 73a of the support portion 73 is spaced from the surface 15a of the support table 15 such that the support portion 73 is retracted and the flexographic printing plate precursor 60 can pass through until the flexographic printing plate precursor 60 is transported into the developing tank 13 and reaches the rear end pressing portion 71.

In the rear end pressing portion 71 as well, the cross-sectional shape of the support portion 73 in a direction orthogonal to the direction of extension and retraction of the support portion 73 is not particularly limited, and the same configuration as that of the rear end pressing portion 70 can be adopted. For example, the cross-sectional shape may be a circular shape or a polygonal shape such as a triangular shape or a quadrangular shape.

In the rear end pressing portions 70 and 71, it is preferable that the base 72, the support portion 73, and the pressing plate 74 are made of stainless steel having excellent corrosion resistance, and austenitic stainless steel and martensitic stainless steel are particularly preferable.

The austenitic stainless steel and the martensitic stainless steel correspond to stainless steels developed for blades, which are original brands of material manufacturers, such as SUS 410, SUS 420J1, and SUS 420J2, as well as SUS 304 and SUS316.

The rear end pressing portions 70 and 71 may be made of a resin, and, in this case, an alkali-resistant resin is preferable. For example, a polyvinyl chloride resin can be used.

The method for manufacturing the flexographic printing plate precursor using the washout processor 10a shown in Figs. 8 and 9 is the same manufacturing method as the method for manufacturing the flexographic printing plate precursor shown in Fig. 7 using the above-described washout processor 10 (see Fig. 1), except that the following points are different.

The flexographic printing plate precursor 60 is transported into the developing tank 13 according to the length of the flexographic printing plate precursor 60 in the transport direction D in step S18 of Fig. 7, and the leading end leader 30 stops at the transport positions P₁ and P₂ (see Fig. 6). In this case, the pressing plate 74 is spaced from the surface 15a of the support table 15 and is disposed at a position where the rear end 60g of the flexographic printing plate precursor 60 can be positioned.

After the leading end leader 30 stops, the base 72 of the rear end pressing portion 70 extends toward the surface 15a of the support table 15, the flexographic printing plate precursor 60 is sandwiched between the pressing plate 74 and the surface 15a of the support table 15, thereby fixing the rear end 60g of the flexographic printing plate precursor 60.

Next, with the rear end 60g of the flexographic printing plate precursor 60 fixed, step S20 described above is executed. Next, development is carried out to remove the non-exposed portion of the flexographic printing plate precursor 60 to obtain an image area which is an exposed portion (step S22). Then, step S24 (inspection step) described above is carried out. As described above, in step S24, it is determined whether or not the development has been properly carried out or not. In a case where the development has been properly carried out, the method for manufacturing the flexographic printing plate precursor 60 ends.

On the other hand, in a case where the development has not been properly carried out, for example, as described above, re-plate making or additional development of the flexographic printing plate precursor 60 that has been developed once is carried out.

Hereinafter, each configuration of the washout processor will be described.

### <Brush>

The brush 51 removes a non-exposed portion (not shown) of the flexographic printing plate precursor 60 for development. For example, the brush 51 is immersed in the developer Q and is disposed on the front surface 60a side of the flexographic printing plate precursor 60 in the transport direction D in the developing tank 13. After the flexographic printing plate precursor 60 is transported into the developing tank 13, the bristles 51b of the brush 51 are brought into contact with the front surface 60a of the flexographic printing plate precursor 60, and the brush 51 is moved by the motor 52 to rub the front surface 60a of the flexographic printing plate precursor 60, thereby removing the non-exposed portion (not shown) of the flexographic printing plate precursor 60 and carrying out development. During this development, a fatigued developer is generated.

Since the brush 51 is disposed by being immersed in the developer Q, the developer Q adhering to the brush 51 is not dried, and the non-exposed portion or the like removed by the brush 51 is prevented from adhering to the brush 51 as development scum.

In the brush 51, in a case where an area of the brush 51 projected onto the front surface 60a of the flexographic printing plate precursor 60 is smaller than an area of the front surface 60a of the flexographic printing plate precursor 60, the brush 51 is brought into partial contact with the entire width of the flexographic printing plate precursor 60 for development. During development, since the brush 51 is small, the brush 51 moves, for example, in the transport direction D and in the direction Dw as described above in order for the brush 51 to uniformly rub the entire front surface 60a of the flexographic printing plate precursor 60, but may be configured to move only in the direction Dw.

A movement path of the brush 51 is determined in advance according to the size of the brush 51, the size and the transport speed of the flexographic printing plate precursor 60, or the like. As a result, the movement path of the brush 51 is programmed in the driving unit, and, based on the program, the driving unit can move the brush 51 along the movement path to carry out development.

As described above, the brush 51 may be a cup brush. The cup brush is smaller than the flexographic printing plate precursor 60. In this case, in a case where an outer shape of a substrate of the cup brush is circular, a diameter thereof is preferably 30 mm to 500 mm, more preferably 100 to 400 mm, and most preferably 200 to 400 mm.

In a case where a shape of the substrate of the cup brush is a brush shape other than a circle, an equivalent circle diameter, that is, a diameter corresponding to the brush area is used as the diameter in a case where the outer shape of the substrate described above is circular.

In addition, the cup brush rotates to perform development, but the number of rotations of the cup brush is preferably 10 revolutions per minute (rpm) to 2000 rpm, more preferably 20 to 800 rpm, and still more preferably 30 to 200 rpm.

By increasing the number of rotations of the cup brush and increasing the rotation speed, the development speed can be increased as described above, and development uniformity also improves.

Herein, as for a mechanism of adhesion of development scum, it is estimated that, during development, development scum is deposited in the cup brush, and is transferred to the flexographic printing plate precursor 60 at a certain timing, causing the development scum to adhere thereto. Therefore, it is necessary to efficiently discharge the development scum from the inside of the cup brush to the outside of the cup brush. Therefore, in a case where the number of rotations of the cup brush is high, the developer in the cup brush is easily discharged to the outside of the cup brush by the rotation, and the development scum in the cup brush can be efficiently discharged to the outside of the cup brush.

In addition, the number of rotations of the cup brush is not limited to a fixed value and may be variable. In a case where the number of rotations of the cup brush is variable, for example, the number of rotations is determined in advance from the initial stage of development to the end of development, and development can be carried out at the determined number of rotations.

The substrate of the brush 51 holds the bristles, and for example, the bristles are tufted in a bundle. The substrate is not particularly limited as long as it can hold the bristles and is not altered by the developer Q.

In addition, the material of the bristles of the brush 51 is not particularly limited, and, for example, a known material used for the development of the flexographic printing plate precursor 60, such as nylon 6,6, nylon 610, nylon 612, polybutylene terephthalate (PBT), and polyethylene terephthalate (PET), can be used as appropriate.

In addition to this, as the material of the bristles of the brush 51, for example, natural fibers such as a palm leaf and any material that can be made into a fibrous form, such as metals, polyamides, polyesters, vinyl chloride, vinylidene chloride, polyimides, and polyacrylonitriles, are suitably used.

A fiber diameter of each bristle of the brush is preferably approximately 10 µ to 1 mm, and the bristles may be tufted in a bundle or individually in clusters of only a few bristles. A tufting interval is preferably approximately 1 to 20 mm, and, in a case of being tufted in a bundle, the diameter of the bundle is preferably approximately 1 to 10 mm. In addition, a length of the bristles of the brush is preferably approximately 2 to 50 mm and more preferably 5 to 25 mm. In a case where the length of the bristles of the brush is 5 to 25 mm, the leading end leader 30 for transport can be passed through, the brush force becomes strong, so that the independent dot performance is achieved, and the development speed is also increased.

The length of each of the bristles may vary in one brush 51, and it is preferable that bristles in a central portion are longer. In addition, the thickness of each of the bristles in one brush 51 may vary, or the density of the bristles in one brush 51 may vary.

In addition, in a case where bristles obtained by adding a fine abrasive material such as alumina or silicon carbide to a nylon thread are used as the material of the bristles of the brush, the development speed can be increased in the first half of development, thereby shortening the development treatment time. As the bristles to which the abrasive material is added, wavy bristles, which are not uncurled bristles and which are called curly bristles, can be used rather than straight bristles. Since the abrasive material is contained, abrasion of the brush can be reduced, and the brush life can be extended. Examples of a commercially available bristle material include Sungrid (product name) manufactured by Asahi Kasei Corporation, Tragrid (product name) manufactured by Toray Industries, Inc., and Tynex (product name) manufactured by DuPont.

In the cup brush, the bristles are tufted onto the substrate. The bristles are provided in a region other than a region where a radius with respect to the center of the substrate is within 10 mm. That is, it is preferable that the bristles are not provided in a region where a radius with respect to a rotation axis is 10 mm, and the bristles are preferably provided in a region other than the region. As described above, in the cup brush, it is preferable that the bristles are not provided in the region where the radius with respect to the rotation axis is within 10 mm, and the bristles are provided in a region where the radius exceeds 10 mm.

In the cup brush, it is preferable to provide the bristles in the region where the radius is within 10 mm, since this makes it easier to discharge the development scum, and also increases the rotation speed, thereby achieving the independent dot performance.

In order to maintain the development speed of the cup brush, it is preferable that the bristles are provided in a region of 30% or more of the substrate. The fact that the bristles are provided in an area of 30% or more of the substrate of the cup brush means that the area of the bristles is 30%.

The cup brush is rotated in a state where the rotation axis of the cup brush passes through the front surface 60a of the flexographic printing plate precursor 60. In this case, in a case where an angle formed by the rotation axis with respect to the front surface 60a of the flexographic printing plate precursor 60 is set as θ, the angle θ is preferably 30° ≤ θ ≤ 90°, more preferably 45° ≤ θ ≤ 90°, and most preferably 60° ≤ θ ≤ 90°. By setting the angle θ to 60° ≤ θ ≤ 90°, the cup brush can be uniformly brought into contact with the front surface 60a of the flexographic printing plate precursor 60, and development can be performed even in a case where the pressure of the cup brush is increased. Therefore, both the development uniformity and the development speed can be increased. As described above, it is most preferable that the rotation axis of the cup brush is perpendicular to the front surface 60a of the flexographic printing plate precursor 60.

The angle θ can be obtained as follows. First, an image in a state where the cup brush is disposed on the front surface 60a of the flexographic printing plate precursor 60 is acquired, and a line corresponding to the rotation axis of the cup brush and a line corresponding to the front surface 60a of the flexographic printing plate precursor 60 are acquired from the image. Next, an angle formed by the two lines is obtained. Accordingly, the angle θ can be obtained.

A state where the rotation axis of the cup brush passes through the front surface 60a of the flexographic printing plate precursor 60 means passing through the front surface 60a of the flexographic printing plate precursor 60 or a surface obtained by expanding the front surface 60a of the flexographic printing plate precursor 60 in a case of the rotation axis or in a case where the rotation axis is extended, and shows a disposition relationship between the cup brush and the flexographic printing plate precursor 60.

Therefore, the rotation axis of the cup brush does not actually pass through the front surface 60a of the flexographic printing plate precursor 60 in some cases depending on the inclination of the rotation axis, but the rotation axis of the cup brush is not limited to actually passing through the front surface 60a of the flexographic printing plate precursor 60 as described above.

### (Rinsing Unit)

The washout processor 10 may have a configuration including a rinsing unit (not shown).

The rinsing unit removes residues, such as latex components and rubber components remaining on the front surface 60a of the developed flexographic printing plate precursor 60 taken out from the developing tank 13, using a rinsing liquid such as a developer. Removing residues, such as latex components and rubber components remaining on the front surface 60a of the flexographic printing plate precursor 60, using a rinsing liquid such as a developer, by the rinsing unit is called a rinsing step.

For example, the developed flexographic printing plate precursor 60 is transported from the developing tank 13 to the outside of the developing tank 13 and is treated in the rinsing unit.

The rinsing unit includes a rinsing liquid supply unit and a liquid drain nozzle.

In the rinsing unit, for example, a rinsing liquid is applied to the front surface 60a of the developed flexographic printing plate precursor 60 from the rinsing liquid supply unit in the form of a spray, for example, and the above-described residues are washed away. The fatigued developer supplied from the rinsing liquid supply unit and the residues, which are washed away and are described above, accumulate in, for example, the developing tank 13.

It is preferable that the rinsing unit is provided such that the rinsing liquid is supplied to a liquid film generated by the developer remaining on the developed flexographic printing plate precursor 60 taken out from the developing tank 13. As the used rinsing liquid supplied from the rinsing unit flows into the developing tank 13, the total amount of waste liquid can be reduced. In particular, in a case where the transport path is in an up-down direction, an effect of reducing the amount of waste liquid is great. Therefore, it is preferable that the used rinsing liquid flows into the developing tank 13 in the rinsing step as well.

The washout processor 10 shown in Fig. 1 has a configuration in which the flexographic printing plate precursor 60 is horizontally transported along the transport direction D, but the configuration of the washout processor is not limited to this, and can also be applied to, for example, a vertical transport type washout processor disclosed in WO2022/024724A in which a flexographic printing plate precursor is transported perpendicularly to a liquid level of a developer corresponding to the developer. In addition, the present invention can also be applied to a device for developing a printing plate by fixing the printing plate to a flat plate called a setter with a pressure sensitive adhesive or the like, and can also be applied to a washout processor for developing a printing plate in a state where a flexographic printing plate precursor is wound around a rotary drum and fixed. In addition to this, the present invention can also be applied to a clamshell type (batch type) washout processor.

### (Flexographic Printing Plate Precursor)

The flexographic printing plate precursor 60 forms a flexographic printing plate used in flexographic printing, and the configuration thereof is not particularly limited. The flexographic printing plate precursor 60 is as thin as several millimeters and has flexibility. Having flexibility means returning from a bent state caused by an acting force to the original state after unloading the force. The size of the flexographic printing plate precursor 60 is, for example, 800 mm × 1200 mm, and 1050 mm × 1500 mm.

The flexographic printing plate precursor 60 is a flexographic printing plate precursor that can be developed with an aqueous developer containing water as a main component and is called a water-developing type flexographic printing plate precursor. In this case, the developer is an aqueous developer.

A known flexographic printing plate precursor that can be developed with the aqueous developer is usable as the flexographic printing plate precursor 60, and a flexographic plate material for computer to plate (CTP) having a surface to which a black layer is applied may be used as the flexographic printing plate precursor 60.

The flexographic printing plate precursor 60 is not limited to a flexographic printing plate precursor that can be developed with an aqueous developer containing water as a main component, and may be a flexographic printing plate precursor that can be developed with a developer containing an organic solvent, for example.

In this case, as the flexographic printing plate precursor 60, for example, a flexographic printing plate precursor including a photopolymerizable layer, an elastomer layer, and an actinic radiation opaque material capable of forming an in-situ mask is used.

The photopolymerizable layer is sensitive to chemical rays and contains a binder, a monomer, and a photoinitiator. The elastomer layer contains at least an elastomer binder and a particulate substance. The actinic radiation opaque material is present on the elastomer layer on a side opposite to the photopolymerizable layer. After imagewise exposure with laser radiation that ablates or evaporates the actinic radiation opaque material from the flexographic printing plate precursor, only a portion of a radiation-insensitive layer that is not removed from the flexographic printing plate precursor remains on the flexographic printing plate precursor to form an in-situ mask.

As the above-described photopolymerizable layer, elastomer layer, and actinic radiation opaque material, for example, those disclosed in paragraphs 0017 to 0063 of JP2015-514232A can be used. The content of which is incorporated in the present specification by reference.

Hereinafter, the developer will be described. As the developer, a developer corresponding to the flexographic printing plate precursor is used.

### <Developer>

As the developer, for example, an aqueous washing solution is used. The aqueous washing solution may be a solution consisting of only water and may be an aqueous solution that contains 50% by mass or more of water and to which a water-soluble compound is added. Examples of the water-soluble compound include surfactants, acids, and alkalis. The aqueous washing solution described above corresponds to the aqueous developer.

Examples of the surfactant include anionic surfactants, nonionic surfactants, cationic surfactants, and amphoteric surfactants, and among the surfactants, anionic surfactants are preferable.

Specific examples of the anionic surfactant include aliphatic carboxylates such as sodium laurate and sodium oleate; higher alcohol sulfate ester salts such as sodium lauryl sulfate, sodium cetyl sulfate, and sodium oleyl sulfate; polyoxyethylene alkyl ether sulfates such as sodium polyoxyethylene lauryl ether sulfate; polyoxyethylene alkyl allyl ether sulfates such as sodium polyoxyethylene octylphenyl ether sulfate and sodium polyoxyethylene nonylphenyl ether sulfate; alkyl sulfonates such as alkyldiphenyl ether disulfonate, sodium dodecyl sulfonate, and sodium dialkyl sulfosuccinate; alkyl allyl sulfonates such as alkyl disulfonate, sodium dodecylbenzene sulfonate, sodium dibutylnaphthalene sulfonate, and sodium triisopropylnaphthalene sulfonate; higher alcohol phosphate ester salts such as lauryl phosphate monoester disodium and sodium lauryl phosphate diester; polyoxyethylene alkyl ether phosphoric acid ester salts such as polyoxyethylene lauryl ether phosphoric acid monoester disodium and polyoxyethylene lauryl ether phosphoric acid diester sodium. These may be used alone or may be used in combination of two or more types. Although a sodium salt is given as a specific example, it is not particularly limited to the sodium salt, and the same effect can be obtained with a calcium salt, an ammonia salt, or the like.

Specific examples of the nonionic surfactant include polyoxyethylene alkyl ethers such as polyoxyethylene oleyl ether and polyoxyethylene lauryl ether, polyoxyethylene polyoxypropylene glycols including polyoxyethylene alkyl phenyl ethers such as polyoxyethylene nonylphenyl ether and polyoxyethylene octylphenyl ether, mono and diesters of polyethylene glycol and fatty acids such as polyethylene glycol monostearate, polyethylene glycol monooleate, and polyethylene glycol dilaurate, fatty acids and sorbitan esters such as sorbitan monolaurate and sorbitan monooleate, esters of sorbitan polyoxyethylene adducts and fatty acids such as polyoxyethylene sorbitan monolaurate, polyoxyethylene sorbitan monostearate, and polyoxyethylene sorbitan trilaurate, esters fatty acids and sorbitol such as sorbitol monopalmitate and sorbitol dilaurate, esters of sorbitol polyoxyethylene adducts and fatty acids such as polyoxyethylene sorbitol monostearate and polyoxyethylene sorbitol diolate, esters of fatty acids and pentaerythritol such as pentaerythritol monostearate, esters of fatty acids and glycerin such as glycerin monolaurate, fatty acid alkanolamides such as lauric acid diethanolamide and lauric acid monoethanolamide, amine oxides such as lauryl dimethylamine oxide, fatty acid alkanolamines such as stearyl diethanolamine, polyoxyethylene alkylamines, triethanolamine fatty acid esters, alkaline salt compounds such as phosphates, carbonates, and silicates. These may be used alone or may be used in combination of two or more types.

Specific examples of the cationic surfactant include primary, secondary and tertiary amine salts such as monostearylammonium chloride, distearylammonium chloride, and tristearylammonium chloride, quaternary ammonium salts such as stearyltrimethylammoum chloride, distearyldimethylammonium chloride, and stearyldimethylbenzylammonium chloride, alkylpyridinium salts such as N-cetylpyridinium chloride and N-stearylpyridinium chloride, N, N-dialkyl morpholinium salts, fatty acid amide salts of polyethylene polyamines, acetic acids of urea compounds of amides of aminoethylethanolamine and stearic acid, and 2-alkyl-1-hydroxyethylimidazolinium chloride. These may be used alone or may be used in combination of two or more types.

Specific examples of the amphoteric surfactant include amino acid types such as sodium laurylamine propionate, carboxybetaine types such as lauryldimethylbetaine and lauryldihydroxyethylbetaine, sulfobetaine types such as stearyldimethylsulfoethyleneammonium betaine, imidazolenium betaine types, and lecithin. These may be used alone or may be used in combination of two or more types.

Specific examples of the acid include inorganic acids or organic acids such as hydrochloric acid, sulfuric acid, nitric acid, phosphoric acid, formic acid, acetic acid, oxalic acid, succinic acid, citric acid, malic acid, maleic acid, and paratoluenesulfonic acid.

Specific examples of the alkali include lithium hydroxide, sodium hydroxide, magnesium hydroxide, potassium hydroxide, calcium hydroxide, calcium oxide, sodium carbonate, sodium hydrogencarbonate, and calcium carbonate.

The developer mainly depends on the chemical properties of the photopolymerizable material to be removed. The developer is not particularly limited to the above-described aqueous washing solution. The developer may be an organic solvent, an aqueous solution, a semi-aqueous solution, or water. Examples of a suitable organic solvent developer include a solvent of an aromatic or aliphatic hydrocarbon, a solvent of an aliphatic or aromatic halohydrocarbon, and a mixture of such a solvent and a suitable alcohol. Another organic solvent developer is disclosed in DE3828551A. A suitable semi-aqueous developer usually contains water, a hydrophilic organic solvent, and an alkaline substance. A suitable aqueous developer usually contains water and an alkaline substance. Another suitable aqueous developer combination is disclosed in US3796602A.

In a case where the non-exposed portion is subjected to solvent development with a developer using an organic solvent, suitable examples of the development solvent include esters such as heptyl acetate and 3-methoxybutyl acetate; hydrocarbons such as petroleum fractions, toluene, and decalin; a mixture of a chlorine-based organic solvent such as tetrachloroethylene and alcohols such as propanol, butanol, and pentanol; water; and ethers such as polyoxyalkylene alkyl ether.

### <Fatigued Developer>

The fatigued developer is a developer containing solid substances generated by removing the non-exposed portion of the flexographic printing plate precursor after imagewise exposure. The expression "containing solid substances" in a developer containing solid substances means a state in which the solid substances are dissolved or dispersed.

The fatigued developer is not particularly limited insofar as the fatigued developer is a developer containing solid substances generated by removing the non-exposed portion of the flexographic printing plate precursor due to development using the developer described above, that is, a developer containing an uncured resin. However, a fatigued developer containing a known photosensitive resin composition of the related art for forming a general photosensitive resin layer may be included.

The uncured resin removed through development may be a photosensitive resin contained in the photosensitive resin composition.

In addition, since it is preferable to set a fatigued developer in a case of developing under a laser ablation masking (LAM) method as a processing target, it is preferable that the uncured resin removed through development is the photosensitive resin contained in the photosensitive resin composition.

In addition, since examples of such a photosensitive resin composition include a composition containing a polymerization initiator, a polymerizable compound, a polymerization inhibitor, and a plasticizer, in addition to the photosensitive resin, the fatigued developer may contain a polymerization initiator, a polymerizable compound, a polymerization inhibitor, a plasticizer, and the like, in addition to the uncured resin.

The present invention is basically configured as described above. Although the washout processor and the method for manufacturing the flexographic printing plate precursor according to the embodiment of the present invention have been described in detail above, the present invention is not limited to the above-described embodiment, and various improvements or modifications may be made without departing from the spirit of the present invention.

### Explanation of References

10: washout processor
12: station
12a: surface
13: developing tank
13b: bottom surface
14: unloading station
14a, 15a: surface
15: support table
16: transport section
20: frame
20a, 20b: member
21: guide rail
22: ball screw
24: driving unit
25: measurement unit
26: adjustment unit
27: plate position adjustment unit
27a: arm
30: leading end leader
30a: housing
30b: arm
30c: support portion
32: plate fixing portion
32a: base
32b: pin
33a: base
40: punching portion
41: driving unit
42: pushing unit
43: recess portion
44: plate attachment portion
48: control unit
49: memory
50: developing section
51: brush
51a: substrate
51b: bristle
52: motor
53: height position adjustment unit
54: distance sensor
56: inspection unit
57: adjustment unit
60: flexographic printing plate precursor
60a: front surface
60b: back surface
60c: side edge
60d: side
60e: corner
60f: leading end part
60g: rear end
70, 71: rear end pressing portion
72: base
73: support portion
73a: end
74: pressing plate
D: transport direction
DL: reverse direction
Dw: direction
P₁, P₂: transport position
Pe: position
Ps: start position
Q: developer

## Claims

1. A washout processor that develops a flexographic printing plate precursor after imagewise exposure using a developer, the washout processor comprising:
a station for attaching the flexographic printing plate precursor; and
a measurement unit that measures at least one of a size or a thickness of the flexographic printing plate precursor and a position of the flexographic printing plate precursor on the station.

2. The washout processor according to claim 1,
wherein the measurement unit includes a camera that images the flexographic printing plate precursor.

3. The washout processor according to claim 1, further comprising:
a plate position adjustment unit that changes the position of the flexographic printing plate precursor on the station based on the at least one of the size or the thickness of the flexographic printing plate precursor measured by the measurement unit and the position of the flexographic printing plate precursor on the station.

4. The washout processor according to any one of claims 1 to 3, further comprising:
a punching portion that punches a leading end part of the flexographic printing plate precursor.

5. The washout processor according to any one of claims 1 to 3, further comprising:
a plate attachment portion that attaches a leading end leader to the flexographic printing plate precursor on the station.

6. The washout processor according to claim 5,
wherein the leading end leader extends and retracts in a direction perpendicular to a surface of the station.

7. The washout processor according to any one of claims 1 to 3,
wherein the flexographic printing plate precursor is developed using the developer in a developing tank, and
the washout processor includes a transport section that positions a transport position of the flexographic printing plate precursor in the developing tank at a predetermined position in a transport direction of the flexographic printing plate precursor during the development.

8. The washout processor according to any one of claims 1 to 3, further comprising:
a developing section that performs the development by removing a non-exposed portion of the flexographic printing plate precursor using the developer,
wherein the developing section has a brush used for the development.

9. The washout processor according to claim 8, further comprising:
a height position adjustment unit that adjusts a position of the brush of the developing section with respect to the developing tank,
wherein the height position adjustment unit adjusts a position of the brush with respect to the flexographic printing plate precursor based on the thickness of the flexographic printing plate precursor obtained by the measurement unit.

10. The washout processor according to any one of claims 1 to 3, further comprising:
an inspection unit that measures a surface shape of the flexographic printing plate precursor after development and inspects a development state.

11. The washout processor according to any one of claims 1 to 3, further comprising:
an adjustment unit that adjusts a position of the measurement unit.

12. The washout processor according to claim 8, further comprising:
a rear end pressing portion that presses a rear end of the flexographic printing plate precursor.

13. A method for manufacturing a flexographic printing plate precursor using the washout processor according to any one of claims 1 to 3.
